# EUROPÄISCHE PATENTANMELDUNG

(11) **EP 4 197 704 A1**
(43) Veröffentlichungstag der Anmeldung: **21.06.2023**
(21) Anmeldenummer: 22213108.8
(22) Anmeldetag: 13.12.2022
(51) Int. Cl.: B25H 3/00, B65G 43/00, B65G 47/00, G08B 21/00, H03K 17/00, G01B 7/00

(54) **POSITIONSDETEKTOR**

(30) Priorität: 17.12.2021 DE 102021133643
(71) Anmelder: Göpel electronic GmbH, 07745 Jena (DE)
(72) Erfinder: Patzer, Florian, 07980 Berga / Elster (DE); Kießlich-Köcher, Philipp, 07545 Gera (DE)
(74) Vertreter: Gleim Petri Oehmke Patent- und Rechtsanwaltspartnerschaft mbB

(57) **Zusammenfassung**

Die Erfindung betrifft einen Positionsdetektor zur Detektion der Positionierung einer ersten Fläche (A) eines beweglichen Werkzeugträgers (1) relativ zu einer zweiten Fläche (B) einer Produktionslinie (2).

Der Positionsdetektor umfasst mindestens drei selbstzentrierende Fixiervorrichtungen (3) an der Produktionslinie (2), durch die die erste Fläche (A) bei einer Zustellung entlang einer mittleren Zustellachse (Z) an der zweiten Fläche (B) definiert positionierbar und fixierbar ist und ein Sensorsystem (4) mit mindestens einem Sensor (41) zur Detektion der Position eines Detektionsobjekts (5) und mindestens einer Feder (42) zur Erzeugung einer definierten Federkraft (F_{F}) zwischen der ersten Fläche (A) und der zweiten Fläche (B) bei erfolgter Zustellung des Werkzeugträgers (1), wodurch die erste Fläche (A) bei fehlerhafter Positionierung oder Fixierung von der zweiten Fläche (B) abdrückbar ist und der mindestens eine Sensor (41) als Abstandssensor so ausgebildet ist, um beim Abdrücken über einen vorgegebenen Abstand hinaus eine Fehlermeldung auszugeben.

## Beschreibung

Die Erfindung betrifft einen Positionsdetektor zur Detektion der Positionierung einer ersten Fläche eines Werkzeugträgers relativ zu einer zweiten Fläche einer Produktionslinie, wobei die zweite Fläche durch mindestens drei selbstzentrierende Fixiervorrichtungen an der Produktionslinie aufgespannt und die erste Fläche des Werkzeugträgers an der zweiten Fläche der Produktionslinie definiert positionierbar und fixierbar ist und mindestens ein Sensor zur Detektion der Position eines Detektionsobjekts vorhanden ist.

Eine exakte Positionierung von Werkzeugkomponenten an Produktionslinien spielt insbesondere bei automatisierten Prozessen eine wichtige Rolle. Dabei ist es insbesondere beim Einsatz von Robotern oder Roboterarmen entscheidend, dass die Positionierung so exakt wie möglich vorgenommen wird und die Position aller am Montageprozess beteiligten Komponenten regelmäßig überprüft wird. Bei Abweichungen der Position oder Fehlern in der Positionierung oder der Fixierung ist es notwendig, ein entsprechendes Signal auszulösen, damit Fehler in der Montage und mögliche Beschädigungen, sowohl von Endprodukten als auch von Komponenten, vermieden bzw. rechtzeitig erkannt werden können.

Positionssensoren sind aus dem Stand der Technik in unterschiedlichen Ausführungen bekannt. Dabei wird in nicht berührungslose bzw. mechanische Positionssensoren und in berührungslose Positionssensoren unterschieden.

Ein mechanischer Positionssensor wird in der EP 0 259 471 B1 offenbart. Dabei wird durch einen Kraftsensor die Kraft gemessen, die über einen Taster auf ein Messglied, das als harte Feder ausgeführt ist, ausgeübt wird. Der Taster kann als Positionssensor eines Ventils oder eines Fluidzylinders verwendet werden oder als Winkelmesseinrichtung ausgeführt sein.

Berührungslose Kraftsensoren benötigen in der Regel ein Detektionsobjekt, das ein vom Sensor gemessenes elektromagnetisches Feld durch seine Positionierung beeinflusst. Ein berührungsloser Kraftsensor wird in der DE 10 2014 219 009 A1 offenbart. Der Positionssensor erfasst die Position eines magnetischen Objekts durch das Messen einer Impedanz an einer planaren Spule, wobei sich die Impedanz abhängig von der Position des magnetischen Objekts ändert.

Aus dem Stand der Technik sind zudem unterschiedlichste Positionsdetektoren bekannt. Die EP 1 862 767 A2 offenbart einen Positionsdetektor, der die Position eines translatorisch verschiebbaren Teils detektiert. An dem verschiebbaren Teil sind Magneten angeordnet, die bei entsprechender Positionierung des verschiebbaren Teils zwei nebeneinander in einer Ebene angeordnete Reedkontakte betätigen. Ein dritter Reedkontakt ist in einem Abstand zur Ebene der beiden nebeneinander befindlichen Reedkontakte angeordnet. Dadurch soll gewährleistet werden, dass eine Manipulation durch Fremdmagnetfelder nicht dazu führt, dass fälschlicherweise eine korrekte Positionierung des verschiebbaren Teils durch den Positionsdetektor detektiert wird. Der hier offenbarte Positionsdetektor vermag zwar die korrekte Positionierung eines translatorisch verschiebbaren Teils zu detektieren, zur Überprüfung einer Fixierung des translatorisch verschiebbaren Teils ist jedoch mindestens ein zusätzlicher Detektor notwendig.

Ein weiterer Positionsdetektor ist aus der DE 102 45 865 A1 bekannt. Der dort offenbarte Positionsdetektor überprüft die Positionierung von zwei benachbarten elektronischen Bauteilen oder Befestigungsplatten. Dazu verfügt der Positionsdetektor über Positionier- und Fixiereinrichtungen, die zur Aufnahme von am zu positionierenden Objekt befestigten Zentrierstiften ausgelegt sind. Dabei kann jede der Positionier- und Fixiereinrichtungen über je mindestens einen Sensor zur Anzeige der Position des Zentrierstiftes umfassen. Über die Positionierung der Zentrierstifte kann sichergestellt werden, dass ein zu positionierendes Objekt gegenüber einer Befestigungsplatte korrekt positioniert ist.

Es ist jedoch bei allen aus dem Stand der Technik bekannten Lösungen stets mindestens ein Detektor an jeder Fixiereinrichtung notwendig, um die korrekte Positionierung und die fehlerfreie Fixierung eines Werkzeugträgers in allen möglichen Freiheitsgraden zu gewährleisten. Durch das Vorhandensein von mehr als einem Detektor pro Fixiereinrichtung erhöht sich der apparative Aufwand zur Positionierung eines Werkzeugträgers beträchtlich, weil entweder eine entsprechende Signalauswertung oder mehrere Signale bzw. Anzeigen notwendig sind, um eine korrekte Positionierung und Fixierung zu erkennen. Außerdem erhöht sich die Störanfälligkeit des gesamten Kontroll- bzw. Sicherheitssystems mit einer steigenden Anzahl von Detektoren, die an der Zustandsprüfung beteiligt sind.

Es ist die Aufgabe der Erfindung eine neue Möglichkeit zur Erkennung Positionierzustands eines beweglichen Werkzeugträgers zu schaffen, mit der die Positionierung einer ersten Fläche des Werkzeugträgers relativ zu einer zweiten Fläche an einer Produktionslinie zuverlässig detektiert werden kann und überprüft werden kann, ob eine gewünschte Positionierung des Werkzeugträgers und dessen dauerhafte Fixierung an mehreren Fixiervorrichtungen fehlerfrei vorliegt.

Diese Aufgabe wird bei einem Positionsdetektor zur Detektion der Positionierung einer ersten Fläche eines beweglichen Werkzeugträgers relativ zu einer zweiten Fläche einer Produktionslinie, wobei die zweite Fläche durch mindestens drei selbstzentrierende Fixiervorrichtungen an der Produktionslinie aufgespannt und definiert ist und die erste Fläche des Werkzeugträgers an der zweiten Fläche der Produktionslinie definiert positionierbar und fixierbar ist, und mindestens ein Sensor zur Detektion einer Position mindestens eines Detektionsobjekts vorhanden ist, dadurch gelöst, dass das Sensorsystem den mindestens einen Sensor und mindestens eine Feder aufweist, die bei erfolgter Zustellung des Werkzeugträgers entlang einer mittleren Zustellachse, die als Orthogonale durch einen Flächenschwerpunkt der zweiten Fläche definiert ist, so ausgelegt ist, um eine definierte Federkraft gegen die erste Fläche und die zweite Fläche der Produktionslinie auszuüben, wodurch die erste Fläche bei fehlerhafter Positionierung oder bei fehlerhafter Fixierung von der zweiten Fläche abdrückbar ist, und der mindestens eine Sensor ein Abstandssensor und so ausgelegt ist, dass bei einem Abdrücken der ersten Fläche von der zweiten Fläche über einen vorgegebenen Abstand zwischen Sensor und Detektionsobjekt hinaus ein Signal erzeugbar ist, um eine Fehlermeldung über eine fehlerhafte Positionierung oder fehlerhafte Fixierung auszugeben.

Es sind mindestens drei Fixiervorrichtungen vorhanden, um eine definierte Positionierung in allen Freiheitsgraden zu gewährleisten. Vorteilhaft sind genau drei nicht kollinear angeordnete Fixiervorrichtungen vorhanden, damit eine Dreipunktauflage erreichbar ist, bei der die erste Fläche an der zweiten Fläche stabil anliegt oder parallel ausgerichtet ist.

Vorteilhaft sind vom Sensorsystem der mindestens eine Sensor und die mindestens eine Feder jeweils entweder an der ersten Fläche oder an der zweiten Fläche befestigt.

Besonders bevorzugt weist das Sensorsystem genau einen Sensor und genau eine Feder auf, die bei Zustellung des Werkzeugträgers entlang der mittleren Zustellachse ausgerichtet sind.

In einer anderen bevorzugten Ausführung weist das Sensorsystem eine Mehrzahl von Federn oder Sensoren auf, wobei die Mehrzahl der Sensoren oder der Federn innerhalb der sich um die mittlere Zustellachse erstreckenden zweiten Fläche angeordnet ist.

Am Werkzeugträger sind korrespondierend zu den Fixiervorrichtungen entsprechende Halterungen angeordnet. Bei einer Zustellung des Werkzeugträgers zu der Produktionslinie ist jede Halterung an der korrespondierenden Fixiervorrichtung fixierbar.

Zweckmäßig weist das Sensorsystem genau einen Sensor auf, der auf der mittleren Zustellachse angeordnet ist. Durch ein Vorhandensein von nur einem Sensor vereinfacht sich der Aufbau des Positionsdetektors. Um dennoch eine hohe Genauigkeit und eine Zuverlässigkeit bei der Detektion der Positionierung und/oder der Fixierung zu gewährleisten, ist der Sensor auf der mittleren Zustellachse angeordnet.

Vorteilhaft weist das Sensorsystem genau eine Feder auf, die auf der mittleren Zustellachse angeordnet ist. Durch ein Vorhandensein von nur einer Feder vereinfacht sich der Aufbau des Positionsdetektors. Um dennoch eine hohe Genauigkeit der Detektion bei der Detektion der Positionierung und/oder der Fixierung zu gewährleisten, ist die Feder auf der mittleren Zustellachse angeordnet, wodurch auf alle Fixiervorrichtungen eine im Wesentlichen gleiche Federkraft ausgeübt werden kann.

Bevorzugt ist der mindestens eine Sensor innerhalb der mindestens einen Feder angeordnet, um einen Schutz des Sensors gegenüber äußeren mechanischen Einflüssen zu gewährleisten.

In einer alternativen Ausführung ist der mindestens eine Sensor außerhalb der mindestens einen Feder angeordnet. Das kann insbesondere dann vorteilhaft sein, wenn durch die Anordnung des Sensors innerhalb der Feder eine Funktion des Sensors beeinträchtigt wird.

Vorteilhaft ist der mindestens eine Sensor als berührungsloser Sensor ausgeführt.

Dabei kann der mindestens eine Sensor vorteilhaft ausgebildet sein als kapazitiver Sensor, um vorzugsweise Abstände zu detektieren, die klein gegenüber dem Sensordurchmesser sind, oder als induktiver Sensor, um bevorzugt Abstände zu detektieren, die groß gegenüber dem Sensordurchmesser sind, oder als optischer Sensor, um insbesondere Abstände zu detektieren, die groß gegenüber dem Sensordurchmesser sind.

Der mindestens eine Sensor kann in einer weiteren Gestaltung auch als mechanischer Sensor ausgeführt sein. Mechanische Sensoren sind in der Regel kostengünstig und zuverlässig, jedoch nicht für jede Anordnung von Werkzeugträger und Produktionslinie geeignet.

Vorteilhaft ist ein Federweg und eine Federkonstante der mindestens einen Feder so gewählt, dass eine Federkraft hinreichend groß ist, um bei fehlerhafter Positionierung oder bei fehlerhafter Fixierung mindestens die Gewichtskraft und die Haftreibung des Werkzeugträgers zu überwinden und die erste Fläche von der zweiten Fläche über den vorgegebenen Abstand zwischen Sensor und Detektionsobjekt hinaus abzudrücken, sodass der mindestens eine Sensor eine Fehlermeldung auslöst.

Zweckmäßig ist der Sensor so ausgelegt, um bei einer Über-/ oder Unterschreitung eines vorgegebenen Sollwerts oder Sollwertbereichs ein optisches Signal und/oder ein akustisches Signal auszulösen. Er kann aber auch eine Abschaltung für die Funktion des Werkzeugträgers auslösen

Das Detektionsobjekt kann, je nach Ausführung des Sensors, elektromagnetische oder optische Eigenschaften aufweisen, die eine Detektion durch den Sensor ermöglichen. Vorteilhaft ist entweder die erste Fläche oder die zweite Fläche das Detektionsobjekt. Je nach Ausführung des Sensors wird kein zusätzliches Detektionsobjekt benötigt. Insbesondere bei einem kleinen Bauraum ist es sinnvoll, auf zusätzliche Detektionsobjekte zu verzichten.

Die Ausführung der mindestens einen Feder ist für die Erfindung nur insofern wesentlich, als dass die mindestens eine Feder bei erfolgter Zustellung des Werkzeugträgers an die Produktionslinie eine definierte Federdruckkraft gegen die erste Fläche des Werkzeugträgers und die zweite Fläche der Produktionslinie ausübt. Dazu kann jede geeignete Feder genutzt werden. Bevorzugt kann die mindestens eine Feder als Blattfeder ausgeführt sein. Ebenso bevorzugt kann die mindestens eine Feder als Torsionsfeder ausgeführt sein.

Die beschriebenen Ausführungen der Erfindung sind Ausführungsbeispiele, die keine Beschränkung der Allgemeinheit darstellen. Ein Positionsdetektor mit einer größeren Anzahl an Sensoren und/oder einer größeren Anzahl an Federn ist insbesondere dann notwendig, wenn die erste Fläche und/oder die zweite Fläche große Flächen sind.

Insbesondere können alle beschriebenen Komponenten des Positionsdetektors sowohl auf der ersten, als auch auf der zweiten Fläche angeordnet sein. Lediglich die relative Anordnung der Komponenten zueinander und deren Verteilung innerhalb der Flächen ist für die Erfindung wesentlich.

Der Werkzeugträger ist ein beweglicher Untersatz, auf oder an dem mindestens ein Werkzeug und/oder mindestens eine Werkzeugkomponente angebracht ist.

Die Produktionslinie ist eine Fertigungslinie, an der Rohstoffe, Komponenten oder Produkte geprüft oder kontrolliert und/oder Komponenten oder Produkte gefertigt werden. Die Produktionslinie kann insbesondere ein Fließband sein, an dem als Komponenten für Fahrzeuge oder Fahrzeuge gefertigt und/oder geprüft werden.

Die Flächen von Werkzeugträger und Produktionslinie sind im Sinne der Erfindung im Wesentlichen ebene oder gekrümmte Bereiche (z.B. Planflächen, Zylinderflächen oder Sphären), deren definierte, vorzugsweise parallele Positionierung zueinander fixiert und gehalten werden soll. Ob oder wie viele Objekte, wie beispielsweise Sensoren, Federn, Detektionsobjekte oder Fixiervorrichtungen, in diesen Bereichen angeordnet sind, ist dabei zunächst unwesentlich.

Die Erfindung soll nachfolgend durch Ausführungsbeispiele anhand von Zeichnungen näher beschrieben werden. Hierzu zeigen:
- Fig. 1: eine Ansicht einer ersten Ausführung eines Positionsdetektors und einer Zustellung eines Werkzeugträgers entlang einer mittleren Zustellachse zu einer Produktionslinie,
- Fig. 2A: eine Ansicht einer Ausführung eines kapazitiven Sensors und einer Feder gemäß Fig. 1,
- Fig. 2B: eine Ansicht einer Ausführung eines Detektionsobjekts gemäß Fig. 1,
- Fig. 3: eine Ansicht einer zweiten Ausführung des Positionsdetektors und der Zustellung des Werkzeugträgers entlang der mittleren Zustellachse zu der Produktionslinie,
- Fig. 4: eine Ansicht einer dritten Ausführung des Positionsdetektors und der Zustellung des Werkzeugträgers entlang der mittleren Zustellachse zu der Produktionslinie,
- Fig. 5: eine Ansicht einer Ausführung eines mechanischen Sensors und einer Feder,
- Fig. 6: eine Ansicht einer Ausführung eines optischen Sensors und einer Feder,
- Fig. 7: eine Ansicht einer vierten Ausführung des Positionsdetektors und der Zustellung des Werkzeugträgers entlang der mittleren Zustellachse zu der Produktionslinie.

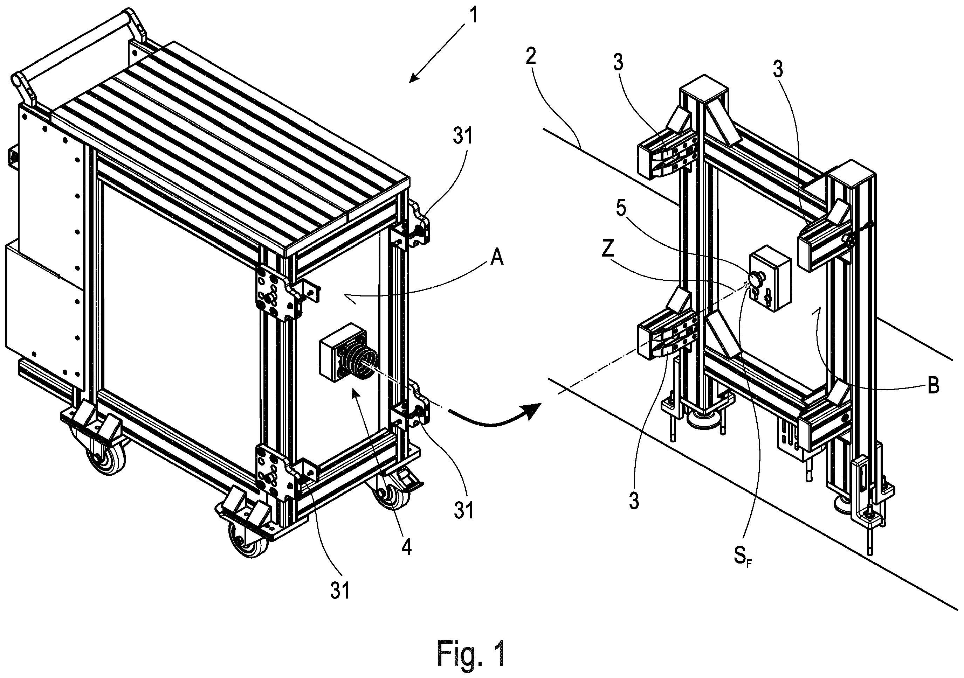

Eine erste Ausführung eines Positionsdetektors ist in **Fig. 1** dargestellt. Der Positionsdetektor gemäß Fig. 1 umfasst vier Fixiervorrichtungen 3 und ein Sensorsystem 4 mit einer Feder 42 sowie einem in der Feder 42 angeordneten Sensor 41. Das Sensorsystem 4 befindet sich auf einer ersten Fläche A eines Werkzeugträgers 1 und die Fixiervorrichtungen 3 befinden sich auf einer zweiten Fläche B einer Produktionslinie 2. Auf der zweiten Fläche B ist zudem ein Detektionsobjekt 5 angeordnet.

Die an den Eckpunkten der zweiten Fläche B angeordneten Fixiervorrichtungen 3. definieren einen Flächenschwerpunkt S_{F} in der zweiten Fläche B, durch den eine mittlere Zustellachse Z verläuft, entlang der die erste Fläche A an die zweite Fläche B zustellbar ist. Am Werkzeugträger 1 sind korrespondierend zu den Fixiervorrichtungen 3 entsprechende Halterungen 31 angeordnet. Bei einer Zustellung des Werkzeugträgers 1 zu der Produktionslinie 2 ist jede Halterung 31 an der korrespondierenden Fixiervorrichtung 3 fixierbar.

Vorteilhaft ist der eine Sensor 41 und die eine Feder 42 auf der mittleren Zustellachse Z angeordnet, wie in Fig. 1 dargestellt. Dadurch wird eine Genauigkeit der Detektion von Positionierung und/oder Fixierung erhöht, da auf alle Fixiervorrichtungen 3 eine im Wesentlichen gleiche Federkraft F_{F} ausgeübt werden kann und der Sensor 41 eine fehlerhafte Fixierung an jeder der Fixiervorrichtungen 3 gleichermaßen detektieren kann. Bei korrekter Zustellung ist die erste Fläche A an der zweiten Fläche B an allen Fixiervorrichtungen 3 fixiert und somit korrekt positioniert. Eine korrekte Positionierung des Werkzeugträgers 1 wird durch die selbstzentrierenden Fixiervorrichtungen 3 gewährleistet.

Bei fehlerhafter Zustellung des Werkzeugträgers 1 ist das Sensorsystem 4 dazu ausgelegt, eine fehlerhafte Positionierung und/oder eine fehlerhafte Fixierung zu detektieren. Der Sensor 41 ist als Abstandssensor ausgelegt und detektiert einen Abstand zu einem Detektionsobjekt 5. Entspricht der detektierte Abstand nicht einem definierten Sollwert oder liegt nicht in einem definierten Sollwertbereich, gibt der Sensor 41 ein akustisches Signal und/oder ein optisches Signal ab. Um zu vermeiden, dass fälschlicherweise eine korrekte Positionierung und/oder eine korrekte Fixierung detektiert wird, ist die Feder 42 dazu ausgelegt, bei erfolgter Zustellung des Werkzeugträgers 1 eine definierte Federkraft F_{F}, die beispielsweise entlang der mittleren Zustellachse Z wirken kann, gegen die erste Fläche A des Werkzeugträgers 1 und die zweite Fläche B der Produktionslinie 2 auszuüben. Dadurch ist der Positionsdetektor in der Lage, nicht nur eine fehlerhafte Positionierung, sondern auch eine fehlerhafte Fixierung, mit nur einem Sensor 41 zu detektieren. Vorteilhaft ist die Federkraft F_{F} hinreichend groß, um bei fehlerhafter Positionierung oder bei fehlerhafter Fixierung eine Gewichtskraft F_{G} und eine Haftreibung des Werkzeugträgers 1 zu überwinden. Die Größe der Federkraft F_{F} hängt insbesondere von einer Federkonstante D_{F} der Feder 42 und einem Federweg L_{F} bzw. einer Änderung des Federwegs L_{F} der Feder 42 infolge der Zustellung des Werkzeugträgers 1 ab.

Eine exakte Detektion der Positionierung und/oder der Fixierung sind insbesondere dann notwendig, wenn auf oder an dem Werkzeugträger 1 mindestens ein Werkzeug oder mindestens eine Werkzeugkomponente angeordnet ist, das bzw. die eine hohe Präzision erfordert, wie beispielsweise ein Roboterarm, eine Kontrollvorrichtung oder eine Messvorrichtung.

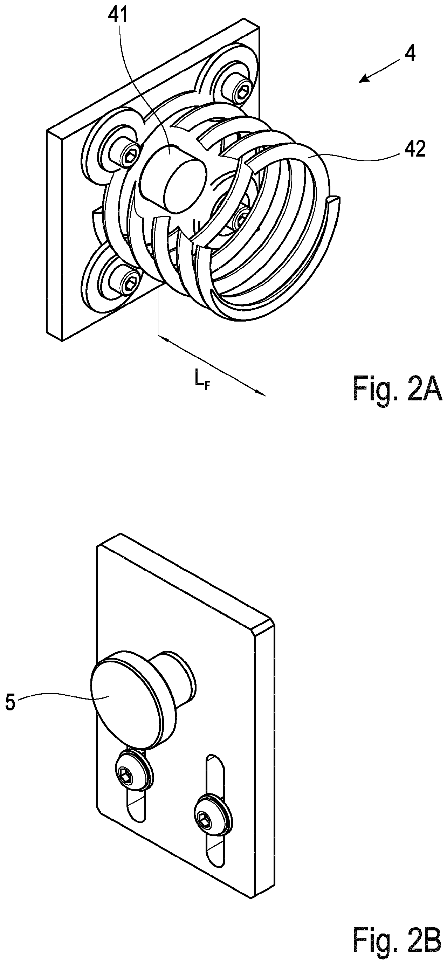

Eine Ausführung einer Feder 42 und eines Sensors 41 gemäß Fig. 1 ist in **Fig. 2A** dargestellt. Die Feder 42 ist als zylindrische Torsionsfeder mit konstantem Windungsdurchmesser und der Sensor 41 ist als berührungsloser kapazitiver Sensor ausgeführt. Der Sensor 41 ist innerhalb der Feder 42 angeordnet, wodurch er gegen äußere mechanische Einflüsse weitgehend geschützt ist. Der Sensor 41 bildet mit dem Detektionsobjekt 5 einen elektrischen Kondensator, wobei der Abstand von Sensor 41 und Detektionsobjekt 5 eine Kapazität bestimmt. Die Verwendung eines kapazitiven Sensors ist in der Regel dann sinnvoll, wenn der Sollwert für den detektierten Abstand kleiner als ein Sensordurchmesser ist.

Eine Ausführung eines Detektionsobjekts 5 gemäß Fig. 1 ist in **Fig. 2B** dargestellt. Das Detektionsobjekt 5 dient als Bezugsobjekt für den Sensor 41. Der Sensor 41 ist in jeder Ausführung dazu ausgelegt, den Abstand zu dem Detektionsobjekt 5 zu detektieren und bei einer Über-/ oder Unterschreitung eines vorgegebenen Sollwerts oder Sollwertbereichs ein Signal auszulösen. Eine Signaleinrichtung, beispielsweise ein Lautsprecher oder eine Lampe, ist dazu ausgelegt, einem Nutzer das Signal zu übermitteln, mit dem eine fehlerhafte Positionierung und/oder Fixierung des Werkzeugträgers 1 an der Produktionslinie 2 angezeigt wird.

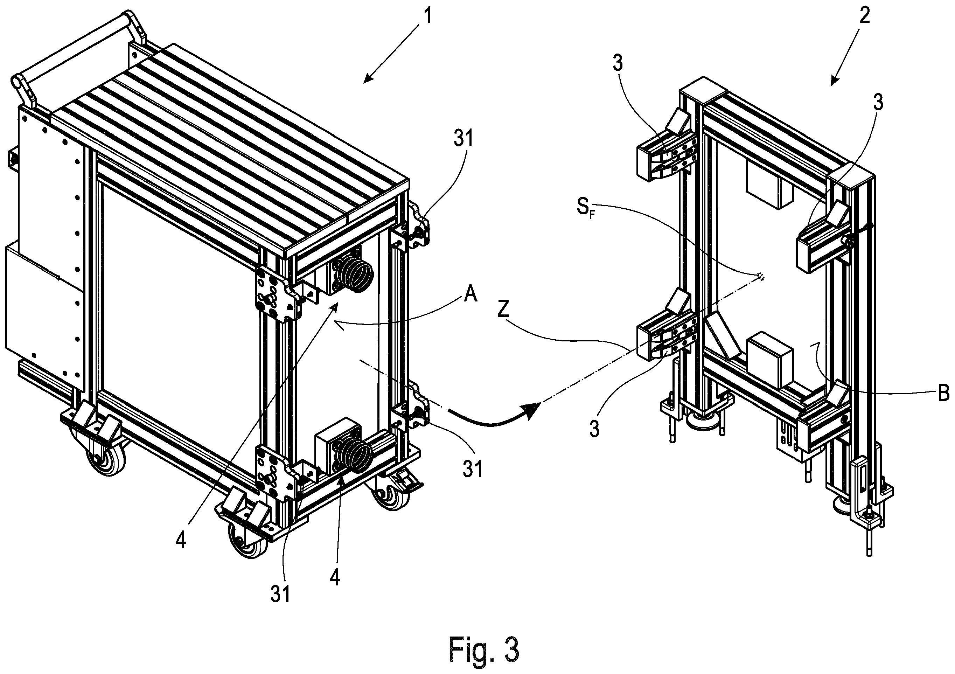

Das Sensorsystem 4 kann zwei Federn 42 und zwei Sensoren 41 umfassen, wie in der in **Fig. 3** dargestellten zweiten Ausführung. Das Vorhandensein von mehr als einer Feder 42 hat den Vorteil, dass eine gewünschte Verteilung der auf die erste Fläche A wirkenden Federkraft F_{F} vorgebbar ist. Vorteilhaft sind die Federn 42 symmetrisch um den Flächenschwerpunkt S_{F} angeordnet, um eine Federkraft F_{F} auf die erste Fläche A auszuüben und um sicher zu stellen, dass auf jede Fixiervorrichtung 3 zumindest ein Anteil der Federkraft F_{F} wirkt. Besonders vorteilhaft sind die Federn 42 so angeordnet, dass auf jede Fixiervorrichtung 3 der gleiche Anteil der Federkraft F_{F} wirkt. Es kann bei begrenztem Bauraum außerdem von Vorteil sein, mehrere Federn 42 zu verwenden. Wird eine hohe Federkraft F_{F} bei einem begrenzten Bauraum benötigt, kann eine Aufteilung der Federkraft F_{F} auf mehrere Federn 42 notwendig sein.

Das Vorhandensein von mehr als einem Sensor 41 hat den Vorteil, dass die Genauigkeit der Detektion der Positionierung und/oder der Fixierung gegenüber Anordnungen mit nur einem Sensor 41 erreicht werden kann.

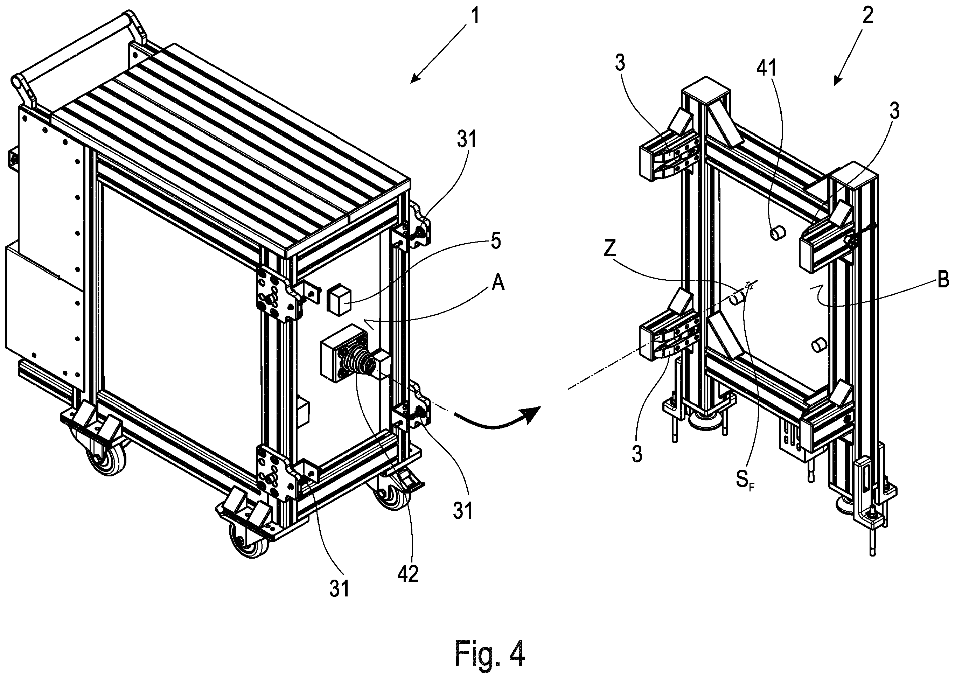

Das Sensorsystem 4 kann eine Feder 42 und drei Sensoren 41 umfassen, wie in der in **Fig. 4** dargestellten dritten Ausführung gezeigt. Die Sensoren 41 sind in einem regelmäßigen Dreieck symmetrisch um den Flächenschwerpunkt S_{F} auf der zweiten Fläche B angeordnet.

Die Feder 42 ist als kegelförmige Torsionsfeder ausgeführt und auf der ersten Fläche A angeordnet. Dadurch, dass sich ein Windungsdurchmesser von einem Federende zum anderen Federende verkleinert, nimmt die Federkraft F_{F} mit einer Änderung des Federwegs L_{F} nicht linear zu. Eine Federkennlinie verläuft somit nichtlinear. Dafür ist eine Auflagefläche der Feder 42 an einem Federende jedoch verkleinert, was die Stabilität und Flexibilität der Anordnung beeinträchtigen kann.

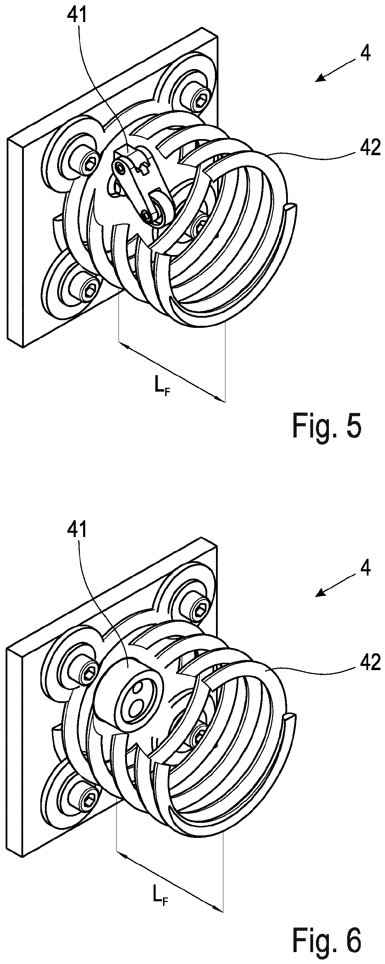

Eine weitere Ausführung einer Feder 42 und eines Sensors 41 ist in **Fig. 5** dargestellt. Der Sensor 41 ist als mechanischer Abstandssensor ausgeführt, der einen Abstand über eine mechanische Berührung bzw. Kontaktierung eines Detektionsobjektes 5 detektieren kann.

Eine weitere Ausführung einer Feder 42 und eines Sensors 41 ist in **Fig. 6** dargestellt. Der Sensor 41 ist als optischer Abstandssensor ausgeführt, der einen Abstand mittels optischer Elemente detektieren kann. Dabei kann beispielsweise eine Laufzeit eines Lichts gemessen werden, um den Abstand zu detektieren. Ein Verwenden optischer Abstandssensoren ist insbesondere dann sinnvoll, wenn der Sollwert für den detektierten Abstand groß gegenüber dem Sensordurchmesser ist.

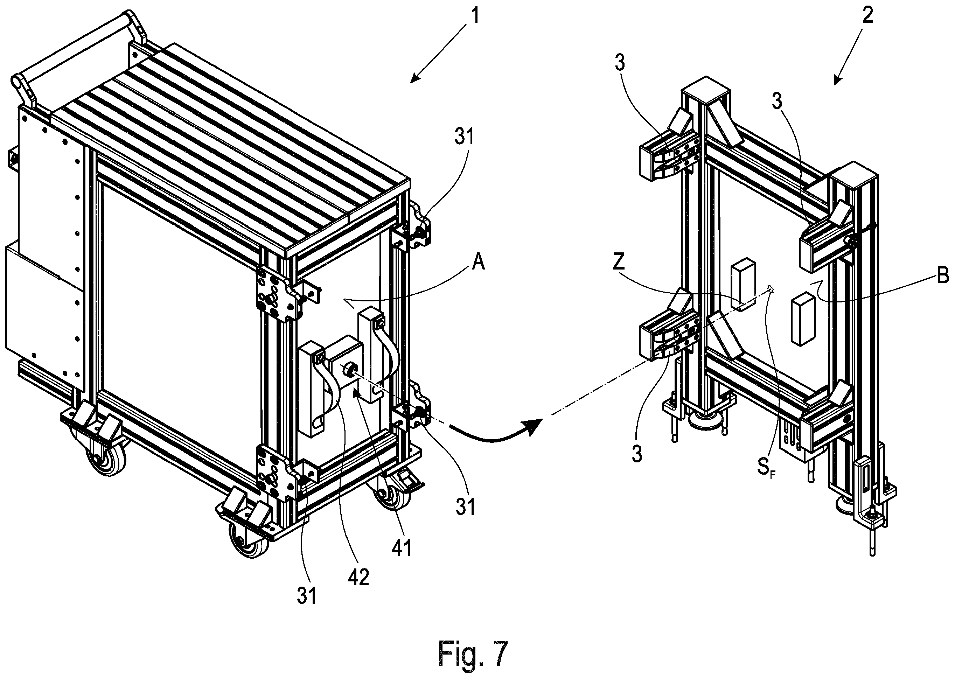

Das Sensorsystem 4 kann zwei Federn 42 und einen Sensor 41 umfassen, wie in **Fig. 7** dargestellt. Der Sensor 41 ist zwischen den Federn 42, die als Blattfedern ausgeführt sind, angeordnet, wodurch er gegen äußere mechanische Einflüsse weitgehend geschützt ist. Das Verwenden von Blattfedern ist insbesondere dann sinnvoll, wenn viel Bauraum zur Verfügung steht. Blattfedern sind simpel in Funktionsweise und Aufbau sowie kostengünstig. Je nach Ausführung weisen sie eine lineare oder eine nichtlineare Federkennlinie auf. Blattfedern weisen zudem in der Regel bessere dämpfende Eigenschaften als Torsionsfedern auf.

Wie in Fig. 7 dargestellt, kann auch eine der Flächen A oder B, konkret die zweite Fläche B, als Detektionsobjekt 5 verwendet werden. Insbesondere bei der Verwendung eines optischen Sensors kann das Vorhandensein eines Detektionsobjekts 5 überflüssig sein. Unter Umständen muss dafür jedoch die zweite Fläche B entsprechend präpariert sein. Die zweite Fläche B kann beispielsweise mit einer reflektierenden Schicht beschichtet sein.

Der Sensor 41 kann, wie ebenfalls in Fig. 7 dargestellt, als induktiver Sensor ausgeführt sein. Ein Verwenden induktiver Abstandssensoren ist insbesondere dann sinnvoll, wenn der Sollwert für den detektierten Abstand groß gegenüber dem Sensordurchmesser ist.

### Bezugszeichenliste

- 1: Werkzeugträger
- 2: Produktionslinie
- 3: Fixiervorrichtung
- 31: Halterung
- 4: Sensorsystem
- 41: Sensor
- 42: Feder
- 5: Detektionsobjekt

- A: erste Fläche
- B: zweite Fläche
- D_{F}: Federkonstante
- F_{F}: Federdruckkraft
- F_{G}: Gewichtskraft
- L_{F}: Federweg
- S_{F}: Flächenschwerpunkt
- Z: mittlere Zustellachse

## Patentansprüche

1. Positionsdetektor zur Detektion der Positionierung einer ersten Fläche (A) eines beweglichen Werkzeugträgers (1) relativ zu einer zweiten Fläche (B) einer Produktionslinie (2), wobei
- die zweite Fläche (B) durch mindestens drei selbstzentrierende Fixiervorrichtungen (3) an der Produktionslinie (2) aufgespannt und definiert ist und die erste Fläche (A) des Werkzeugträgers (1) an der zweiten Fläche (B) der Produktionslinie (2) definiert positionierbar und fixierbar ist und
- mindestens ein Sensor (41) zur Detektion der Position eines Detektionsobjekts vorhanden ist,
**dadurch gekennzeichnet, dass**
- ein Sensorsystem (4) den mindestens einen Sensor (41) und mindestens eine Feder (42) umfasst und innerhalb der zweiten Fläche (B) so angeordnet ist, dass
- die mindestens eine Feder (42) bei erfolgter Zustellung des Werkzeugträgers (1) entlang einer mittleren Zustellachse (Z), die als Orthogonale durch einen Flächenschwerpunkt (S_{F}) der zweiten Fläche (B) definiert ist, so ausgelegt ist, um eine definierte Federkraft (F_{F}) gegen die erste Fläche (A) des Werkzeugträgers (1) und die zweite Fläche (B) der Produktionslinie (2) auszuüben, wodurch die erste Fläche (A) bei fehlerhafter Positionierung oder bei fehlerhafter Fixierung von der zweiten Fläche (B) abdrückbar ist, und
- der mindestens eine Sensor (41) ein Abstandssensor und so ausgelegt ist, dass bei einem Abdrücken der ersten Fläche (A) von der zweiten Fläche (B) über einen vorgegebenen Abstand zwischen Sensor (41) und Detektionsobjekt (5) hinaus ein Signal erzeugbar ist, um eine Fehlermeldung über fehlerhafte Positionierung oder fehlerhafte Fixierung auszugeben.

2. Positionsdetektor nach Anspruch 1, **dadurch gekennzeichnet, dass** der mindestens eine Sensor (41) und die mindestens eine Feder (42) jeweils entweder an der ersten Fläche (A) oder an der zweiten Fläche (B) befestigt sind.

3. Positionsdetektor nach Anspruch 1 oder 2, **dadurch gekennzeichnet, dass** das Sensorsystem (4) genau einen Sensor (41) und genau eine Feder (42) aufweist, die bei Zustellung des Werkzeugträgers (1) entlang der mittleren Zustellachse (Z) ausgerichtet sind.

4. Positionsdetektor nach Anspruch 1 oder 2, **dadurch gekennzeichnet, dass** das Sensorsystem (4) eine Mehrzahl von Federn (42) oder Sensoren (41) aufweist, wobei die Mehrzahl der Sensoren (41) oder der Federn (42) innerhalb der sich um die mittlere Zustellachse (Z) erstreckenden zweiten Fläche (B) angeordnet ist.

5. Positionsdetektor nach einem der Ansprüche 1 bis 4, **dadurch gekennzeichnet, dass** der mindestens eine Sensor (41) innerhalb der mindestens einen Feder (42) angeordnet ist.

6. Positionsdetektor nach einem der Ansprüche 1 bis 4, **dadurch gekennzeichnet, dass** der mindestens eine Sensor (41) außerhalb der mindestens einen Feder (42) angeordnet ist.

7. Positionsdetektor nach einem der Ansprüche 1 bis 6, **dadurch gekennzeichnet, dass** der mindestens eine Sensor (41) als berührungsloser Sensor ausgebildet ist.

8. Positionsdetektor nach Anspruch 7, **dadurch gekennzeichnet, dass** der mindestens eine Sensor (41) als kapazitiver, induktiver oder optischer Sensor ausgebildet ist.

9. Positionsdetektor nach einem der Ansprüche 1 bis 6, **dadurch gekennzeichnet, dass** der mindestens eine Sensor (41) als mechanischer Sensor ausgebildet ist.

10. Positionsdetektor nach einem der vorherigen Ansprüche, **dadurch gekennzeichnet, dass** ein Federweg (L_{F}) und eine Federkonstante (D_{F}) der mindestens einen Feder (42) so gewählt sind, dass eine Federkraft (F_{F}) hinreichend groß ist, um bei fehlerhafter Positionierung oder bei fehlerhafter Fixierung mindestens eine Gewichtskraft (F_{G}) und eine Haftreibung des Werkzeugträgers (1) zu überwinden und die erste Fläche (A) von der zweiten Fläche (B) über den vorgegebenen Abstand zwischen Sensor (41) und Detektionsobjekt (5) hinaus abzudrücken, sodass der mindestens eine Sensor (41) eine Fehlermeldung auslöst.

11. Positionsdetektor nach einem der vorherigen Ansprüche, **dadurch gekennzeichnet, dass** der Sensor (41) so ausgelegt ist, um bei einer Über-/ oder Unterschreitung eines vorgegebenen Sollwerts oder Sollwertbereichs des Sensors (41) ein optisches Signal auszulösen.

12. Positionsdetektor nach einem der vorherigen Ansprüche, **dadurch gekennzeichnet, dass** der Sensor (41) so ausgelegt ist, um bei einer Über-/ oder Unterschreitung eines vorgegebenen Sollwerts oder Sollwertbereichs des Sensors (41) ein akustisches Signal auszulösen.
